(19) **Europäisches Patentamt**
**European Patent Office**
**Office européen des brevets**

(11) **EP 2 281 318 B1**

(12) **EUROPÄISCHE PATENTSCHRIFT**

(45) Veröffentlichungstag und Bekanntmachung des Hinweises auf die Patenterteilung:
**10.07.2013 Patentblatt 2013/28**

(21) Anmeldenummer: **09753523.1**

(22) Anmeldetag: **18.05.2009**

(51) Int Cl.:
**H01L 51/50** *(2006.01)*

(86) Internationale Anmeldenummer:
**PCT/DE2009/000701**

(87) Internationale Veröffentlichungsnummer:
**WO 2009/143807 (03.12.2009 Gazette 2009/49)**

(54) **ELEKTRONISCHE VORRICHTUNG**

ELECTRONIC DEVICE

DISPOSITIF ELECTRONIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **30.05.2008 DE 102008025920**
**22.08.2008 DE 102008039361**

(43) Veröffentlichungstag der Anmeldung:
**09.02.2011 Patentblatt 2011/06**

(73) Patentinhaber: **OSRAM Opto Semiconductors GmbH**
**93055 Regensburg (DE)**

(72) Erfinder:
• **SCHMID, Günter**
**91334 Hemhofen (DE)**
• **KRAUSE, Ralf**
**91058 Erlangen (DE)**
• **SEIDEL, Stefan**
**93098 Mintraching (DE)**
• **WEISS, Oliver**
**69221 Dossenheim (DE)**
• **GÄRDITZ, Christoph**
**93051 Regensburg (DE)**
• **SUHONEN, Riikka**
**90630 Oulu (FI)**
• **NIEDERMEIER, Ulrich**
**94339 Leiblfing (DE)**
• **KOZLOWSKI, Fryderyk**
**91056 Erlangen (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
**WO-A-02/074015        US-A1- 2002 101 154**
**US-A1- 2006 068 223    US-A1- 2008 074 038**
**US-A1- 2008 116 536**

**Beschreibung**

Die Erfindung betrifft eine Elektronische Vorrichtung und ein Verfahren zur Herstellung einer elektronischen Vorrichtung.

Diese Patentanmeldung beansprucht die Prioritäten der deutschen Patentanmeldung 10 2008 025 920.9 und der deutschen Patentanmeldung 10 2008 039 361.4, deren Offenbarungsgehalte hiermit durch Rückbezug aufgenommen werden.

Elektronische Vorrichtungen, wie beispielsweise organische Leuchtdioden (OLEDs), bestehen aus einer Abfolge mehrerer funktioneller organischer Schichten. Emissionsschichten weisen dabei ein Matrixmaterial auf, welches mit Emittermolekülen dotiert wird. In der Emissionsschicht werden Exzitonen durch Rekombination von Elektronen und "Löchern" gebildet, die zur Lichtemission führen. Um eine hohe Effizienz der elektronischen Vorrichtung zu erhalten, ist das Verhältnis zwischen Elektronen und "Löchern", die in der Emissionsschicht transportiert werden, entscheidend. Ein nicht ausgeglichenes Verhältnis zwischen Loch- und Elektronentransport resultiert in einer geringen Strahlungseffizienz der Vorrichtung.

Die Druckschrift US 2008/0116536 betrifft ein photosensitives optoelektronisches Bauelement. Das Dokument US 2006/068223 beschreibt eine dotierte Oleb, die mehrere Hostmaterialen aufweist.

Aufgabe der Erfindung ist es, eine elektronische Vorrichtung bereitzustellen, die einen verbesserten Ladungsträgertransport und eine verbesserte Ladungsträgerbalance in den organischen Schichten und damit eine erhöhte Effizienz aufweist. Eine weitere Aufgabe der Erfindung ist es, ein Verfahren zur Herstellung einer elektronischen Vorrichtung bereitzustellen. Diese Aufgaben werden durch ein elektronische Vorrichtung gemäß Anspruch 1 und einem Verfahren zur Herstellung der elektronischen Vorrichtung gemäß Anspruch 12 gelöst. Weitere Ausführungsformen der Vorrichtung und des Verfahrens sind Gegenstand weiterer Ansprüche.

Gemäß einer Ausführungsform wird eine elektronische Vorrichtung bereitgestellt, die ein Substrat, eine erste Elektrode, zumindest eine organische, funktionelle Schicht und eine zweite Elektrode umfasst, wobei die zumindest eine organische funktionelle Schicht zwischen der ersten Elektrode und der zweiten Elektrode angeordnet ist. Beispielsweise kann die erste Elektrode auf dem Substrat, die zumindest eine organische funktionelle Schicht auf der ersten Elektrode und die zweite Elektrode auf der zumindest einen organischen, funktionellen Schicht angeordnet sein. Die zumindest eine organische, funktionelle Schicht weist mindestens ein erstes Matrixmaterial, ein zweites Matrixmaterial und ein drittes Matrixmaterial auf, wobei das dritte Matrixmaterial ein Lowest Unoccupied Molecular Orbital (LUMO), das energetisch niedriger als das LUMO des zweiten Matrixmaterials und das LUMO des ersten Matrixmaterials ist, und wobei das zweite Matrixmaterial ein Highest Occupied Molecular Orbital (HOMO), das energetisch höher als das HOMO des ersten Matrixmaterials und das HOMO des dritten Matrixmaterials ist. Die zumindest eine organische, funktionelle Schicht ist eine Emissionsschicht und mit zumindest einem Emittermaterial dotiert.

Damit wird eine elektronische Vorrichtung bereitgestellt, die mehr als zwei verschiedene Matrixmaterialien in einer organischen funktionellen Schicht umfasst. Dabei können drei verschiedene Matrixmaterialien vorhanden sein, je nach Bedarf auch mehr als drei.

Nach der Molekülorbitaltheorie sind in einem Molekül verschiedene Molekülorbitale mit verschiedenen Energieniveau vorhanden, die von den vorhandenen Elektronen besetzt werden können. Diese Molekülorbitale werden nach zunehmendem Energieniveau besetzt. Das LUMO ist das energetisch niedrigste Molekülorbital, das nicht mehr mit einem Elektron besetzt ist. Das HOMO ist das energetisch am höchsten gelegene Molekülorbital, das noch mit einem Elektron besetzt ist.

Diese elektronische Vorrichtung weist einen verbesserten Ladungsträgertransport und eine verbesserte Ladungsträgerbalance in der organischen funktionellen Schicht auf, und ein anpassbares Verhältnis zwischen Loch- und Elektronentransport. Das erste Matrixmaterial ist dabei so gewählt, dass es eine große Bandlücke, also die Differenz zwischen HOMO und LUMO aufweist, beispielsweise so dass sein HOMO energetisch unter dem HOMO der anderen beiden Matrixmaterialien und sein LUMO energetisch über dem LUMO der anderen beiden Matrixmaterialien liegt.

Weiterhin kann das erste Matrixmaterial ein LUMO aufweisen, das energetisch höher als das LUMO des zweiten Matrixmaterials und das LUMO des dritten Matrixmaterials ist, und ein HOMO, das energetisch niedriger als das HOMO des zweiten Matrixmaterials und das HOMO des dritten Matrixmaterials ist.

Weiterhin kann in der elektronischen Vorrichtung das zweite Matrixmaterial ein LUMO, das energetisch höher als das LUMO des dritten Matrixmaterials ist, und ein HOMO, das energetisch höher als das HOMO des dritten Matrixmaterials ist, aufweisen. Damit kann das erste Matrixmaterial die größte Bandlücke zwischen HOMO und LUMO im Vergleich zum zweiten und zum dritten Matrixmaterial aufweisen und das zweite Matrixmaterial weist eine Bandlücke auf, die zu der Bandlücke des dritten Matrixmaterials energetisch verschoben ist. Damit können auf dem LUMO des dritten Matrixmaterials Elektronen transportiert werden, und auf dem HOMO des zweiten Matrixmaterials Löcher transportiert werden, da diese Energieniveaus jeweils am energetisch günstigsten für den jeweiligen Ladungstransport sind.

Das erste Matrixmaterial kann in der elektronischen Vorrichtung eine Ladungsträgermobilität aufweisen, die geringer ist als die Ladungsträgermobilität des zweiten und des dritten Matrixmaterials. Das erste Matrixmaterial kann ein Ultra Wide Band Gap (UGH)-Material sein, welches eine im Vergleich zu den übrigen Matrixmaterialien große Bandlücke aufweist. Dadurch kann es keinen Anteil am Ladungsträgertransport aufweisen.

Das zweite Matrixmaterial kann weiterhin ein Lochtransportmaterial umfassen und das dritte Matrixmaterial kann ein Elektronentransportmaterial umfassen.

Der Ladungsträgertransport, also der Lochtransport und der Elektronentransport, hängt insbesondere von der Mobilität der Löcher beziehungsweise der Elektronen in einem Material und von der Lage der Energieniveaus HOMO und LUMO der Matrixmaterialien ab. Das HOMO und LUMO eines Materials ist dabei für die Ladungsträgerinjektion verantwortlich.

Zur Erzeugung eines Lochs in der Matrix, die sich aus den drei Matrixmaterialien zusammensetzt, muss beispielsweise ein Elektron aus dem HOMO entfernt werden, was bei einem energetisch tief liegenden HOMO schwieriger ist als bei einem energetisch höher liegenden. Somit ist das zweite Matrixmaterial, das ein höher gelegenes HOMO als das dritte Matrixmaterial aufweist, besser als Lochtransportmaterial geeignet, als das dritte Matrixmaterial. Analoges gilt für die Erzeugung von Elektronen in LUMOs, die bei energetisch tiefer gelegenen LUMOs energetisch begünstigt ist. Somit eignet sich das dritte Matrixmaterial, das ein niedrigeres LUMO als das zweite Matrixmaterial aufweist, als Elektronentransportmaterial.

Sind Löcher und Elektronen erzeugt, spielt weiterhin die Mobilität dieser Ladungsträger in dem Material eine Rolle. Je nachdem, wie diese beiden Faktoren in einem Material zusammenwirken, kann ein Matrixmaterial als Elektronentransportmaterial oder als Lochtransportmaterial dienen. Dabei findet jeweils auch der Ladungsträgertransport der anderen Ladung statt, es überwiegt jedoch der Transport eines Ladungsträgers. Findet in einem Matrixmaterial kein Ladungsträgertransport statt, wie in einer Ausführungsform der Erfindung in dem ersten Matrixmaterial, so kann das entweder darauf zurückzuführen sein, dass keine Ladungsträger erzeugt werden oder dass keine Mobilität der Ladungsträger vorhanden ist. Neben dem ersten Matrixmaterial können weitere Matrixmaterialien in der organischen, funktionellen Schicht vorhanden sein, die nicht zum Ladungsträgertransport beitragen.

Die Energieniveaus HOMO und LUMO eines Materials können gemessen werden, um geeignete Materialien für erstes, zweites und drittes Matrixmaterial auszuwählen. So kann das HOMO eines Materials mittels Cyclovoltametrie bestimmt werden. Die Bandlücke, also der energetische Unterschied zwischen HOMO und LUMO kann weiterhin mittels Spektroskopie ermittelt werden, bei der die Wellenlänge des emittierten Lichts gemessen wird und daraus die entstandenen Exzitonen und die Bandlücke berechnet wird. Das Energieniveau des LUMO wird dann aus dem ermittelten HOMO und der Bandlücke berechnet. Das HOMO kann alternativ auch mittels Photoelektronenspektroskopie ermittelt werden.

Die Mobilität von Elektronen und Löchern kann von dem Molekülabstand, also dem mittleren Abstand von Ladungsträgertransportierenden Molekülen in dem jeweiligen Matrixmaterial abhängen. Somit spielt die Konzentration eines Matrixmaterials in der Mischung mehrerer Matrixmaterialien eine Rolle. Das erste Matrixmaterial, das im Vergleich zu dem zweiten und dritten Matrixmaterial die größte Bandlücke und die geringste Ladungsträgermobilität aufweist, kann dazu dienen, die Konzentration des zweiten und des dritten Matrixmaterials getrennt voneinander einzustellen. Je nach der gewählten Konzentration des zweiten und dritten Matrixmaterials ändern sich die Abstände zwischen den jeweiligen Molekülen. Der mikroskopische Ladungsträgertransport hängt vom Molekülabstand der Ladungsträgertransportierenden Moleküle in dem jeweiligen Matrixmaterial ab, sodass sich durch die Einstellung der Konzentration die Mobilität von Elektronen und Löchern in der Matrix, die zumindest drei Matrixmaterialien aufweist, getrennt voneinander absolut einstellen lässt.

Nach Miller und Abraham kann die Mobilität folgendermaßen bestimmt werden:

$$\nu_{ij} = \nu_0 \exp[-2\gamma a(\Delta R_{ij}/a)]$$

In diesem Modell wird ein Festkörper schematisch gesehen aus den Plätzen i und j aufgebaut, auf denen sich die Ladungsträger befinden können. Jeder Platz repräsentiert einen lokalisierten Zustand. Der Transport eines Ladungsträgers zwischen den Plätzen i und j wird durch einen Widerstand Rij dargestellt. Die Größe des temperaturabhängigen Widerstands spiegelt dabei den räumlichen Abstand zwischen den Plätzen und die benötigte Aktivierungsenergie für den Übergang wider. Der Parameter y steht für den Abfall der elektronischen Wellenfunktion der Ladungsträger, a ist der Parameter für den durchschnittlichen Gitterabstand. Die Phononenfrequenz $\nu_0$ gibt die Anzahl der Versuche eines Ladungsträgers aus einem lokalisierten Zustand in einen anderen lokalisierten Zustand zu gelangen an, liegt im Bereich von etwa $10^{13}$ s$^{-1}$ und berücksichtigt die Stärke der Elektronenphononkopplung.

Die elektronische Vorrichtung kann weiterhin eine organische, funktionelle Schicht aufweisen, die aus einer Gruppe ausgewählt ist, die Emissionsschichten, Elektronentransportschichten, Lochtransportschichten, Elektronenblockierschichten, Lochblockierschichten, Lochinjektionsschichten, Elektroneninjektionsschichten und Zwischenschichten umfasst. Mit Zwischenschichten werden Schichten bezeichnet, die zwischen zwei Emissionsschichten angeordnet sind.

Je nachdem, was für eine organische, funktionelle Schicht ausgewählt wird, können diese Schichten noch zusätzliche Dotierstoffe enthalten. Die organische, funktionelle Schicht kann eine Emissionsschicht sein und mit zumindest einem Emittermaterial dotiert sein. Emittermaterialien können kleine Moleküle oder Polymere umfassen. Die Konzentration des Emittermaterials in einer Emissionsschicht kann bis zu 10 Gew% betragen. Weiterhin kann das Emittermaterial aufgrund der niedrigen Konzentration in der Emissionsschicht nur eine geringe Ladungsträgermobilität aufweisen und damit nur geringfügig zum Ladungsträgertransport beitragen.

In der Emissionsschicht können auch zwei oder drei Emittermaterialien vorhanden sein. Die Emittermaterialien können beispielsweise ausgewählt sein aus dem grün emittierenden Ir(ppy)$_3$ (Tris(2-phenylpyridin)iridium(III)), dem rot emittierenden Ir(piq)$_3$ (Tris(1-phenylisoquinolin)iridium(III)) oder dem blau emittierenden Firpic (Bis(3,5-Difluoro-2-(2-pyridyl)phenyl-(2-carboxypyridyl)iridium(III)).

Die Konzentrationen des Emittiermaterials und der Matrixmaterialien in der organischen funktionellen Schicht können innerhalb der organischen funktionellen Schicht einen Gradienten aufweisen. Damit kann beispielsweise die Konzentration des Emittermaterials in einem ersten Teilbereich der Schicht höher sein als in einem zweiten Teilbereich der Schicht.

Durch Verzicht auf die Dotierung mit Emittermaterialien lassen sich Transport-, Zwischen- und Blockierschichten herstellen.

In einer elektronischen Vorrichtung können auch mehrere organische, funktionelle Schichten vorhanden sein, wobei die Schichten unterschiedliche Funktionen oder gleiche Funktionen aufweisen können. Beispielsweise kann eine elektronische Vorrichtung eine Abfolge mehrerer funktioneller, organischer Schichten aufweisen, die beispielsweise zusammengesetzt ist aus einer Lochinjektionsschicht, einer Lochtransportschicht, einer ersten Emissionsschicht, einer Zwischenschicht, einer zweiten Emissionsschicht, einer Elektronentransportschicht und einer Elektroneninjektionsschicht. Jede dieser Schichten kann eine Matrix aufweisen, die mindestens ein erstes, ein zweites und ein drittes Matrixmaterial aufweist. Die Matrixmaterialien in den verschiedenen organischen funktionellen Schichten können in allen Schichten gleich oder unterschiedlich gewählt werden.

Je nachdem, wo sich die Emissionsschicht in dem Schichtstapel der elektronischen Vorrichtung befindet, kann dort die Mobilität von Elektronen und Löchern innerhalb dieser Schicht getrennt voneinander optimiert werden, wenn die Emissionsschicht ein erstes, ein zweites und ein drittes Matrixmaterial aufweist. Die Mobilität kann auch über mehrere Schichten hinweg optimiert werden.

Auch wenn die Emissionsschicht, die die drei Matrixmaterialien aufweist, nahe einer Anode oder einer Kathode liegt, kann die Mobilität von Elektronen und Löchern so eingestellt werden, dass das Verhältnis von Löchern und Elektronen in der Emissionsschicht ausgeglichen ist. Je nachdem, welche Ladungsträgersorte eine höhere Beweglichkeit aufweisen soll, kann die Matrix eine höhere Konzentration des jeweiligen Matrixmaterials enthalten. So kann in der Emissionsschicht, unabhängig von der Lage der Emissionsschicht der elektronischen Vorrichtung, eine hohe Anzahl an Exzitonen gebildet werden.

Wenn die organische, funktionelle Schicht eine Emissionsschicht mit einem Emittermaterial ist, kann das LUMO des Emittermaterials energetisch niedriger als das LUMO des ersten, zweiten und dritten Matrixmaterials sein und das HOMO des Emittermaterials energetisch höher als das HOMO des ersten, zweiten und dritten Matrixmaterials sein. Somit ist die Bandlücke zwischen HOMO und LUMO des Emittermaterials kleiner als die Bandlücken der drei Matrixmaterialien und liegt zudem energetisch zwischen allen Bandlücken aller Matrixmaterialien. Ein ambipolarer Ladungstransport in einer Emissionsschicht ist somit möglich.

Die Moleküle des zweiten und dritten Matrixmaterials transportieren bevorzugt nur jeweils eine Ladungsträgersorte, Löcher oder Elektronen, somit bilden sich auf ihnen keine Exzitonen. Damit wird die Lebensdauer der Materialien erhöht, da keine Degradation durch Anregungsenergie stattfinden kann. Zwischen den verschiedenen Molekülen der Matrixmaterialien entstehen angeregte Zustände (Eximere), die ihre Anregungsenergie durch Energietransfer auf die Emittermoleküle übertragen können. Somit wird die Effizienz der elektronischen Vorrichtung weiterhin erhöht.

Eine elektronische Vorrichtung kann auch mehrere Emissionsschichten aufweisen, beispielsweise um phosphoreszente und fluoreszente Emittermaterialien in einer Vorrichtung zu kombinieren. Dann kann das Einfügen einer Zwischenschicht zwischen den Emissionsschichten notwendig sein, die beispielsweise ambipolare Ladungstransporteigenschaften aufweisen kann. Dies ist durch die Kombination von drei Matrixmaterialien möglich.

Durch Einstellung der Ladungsträgermobilität mit Hilfe der drei Matrixmaterialien ist es möglich, die Lage der Rekombinationszone in einer Emissionsschicht gezielt zu beeinflussen. Die Rekombinationszone kann sich dabei innerhalb einer Schicht oder über mehrere Schichten verteilt befinden. Durch die Einführung der ersten Matrix, die keinen Ladungstransport aufweist, innerhalb einer Emissionsschicht sinkt der absolute Wert der Ladungsträgermobilität. Daraus ergibt sich eine Rekombinationszone, die Zone in der Exzitonen gebildet werden, die von den Rändern einer emittierenden Schicht zur Mitte hin verschoben wird. Dies erhöht die Effizienz der Vorrichtung, da unter anderem die nicht strahlende Abregung von Exzitonen (Quenching) vermindert wird und mehr Exzitonen in der eigentlichen Emissionsschicht gebildet werden, statt in den angrenzenden Schichten.

Bei der elektronischen Vorrichtung kann es sich um eine strahlungsemittierende Vorrichtung beispielsweise um eine organische Licht emittierende Vorrichtung handeln. Diese Licht emittierende Vorrichtung kann eine organische, Licht emittierende Diode (OLED) sein.

Beispielsweise ist eine organische, funktionelle Schicht bei einem Transistor zwischen einer ersten und zweiten Elektrode angeordnet. Weiterhin ist eine dritte Elektrode vorhanden. Die Elektroden können aus Gate-, Source- und Drain-Elektrode ausgewählt sein. Ein Transistor kann zum Schalten oder Verstärken von elektrischen Signalen verwendet werden.

Bei einer Solarzelle kann Licht in elektrische Energie umgewandelt werden. Hier ist eine organische, funktionelle Schicht zwischen einer ersten und einer zweiten Elektrode angeordnet, wobei zumindest eine der Elektroden transparent ausgeformt ist.

Die Vorrichtung kann in einer organischen funktionellen Schicht als erstes Matrixmaterial beispielsweise mCP (m-Bis(N-carbazolylbenzol)), als zweites Matrixmaterial, das ein Lochtransportmaterial sein kann, TCTA (9H-carbazol, 9,9',9"-(1,3,5-Benzoltriyl)tris-(9CI)), und als drittes Matrixmaterial, das ein Elektronentransportmaterial sein kann, beispielsweise TPBi (1,3,5-Tris(N-Phenylbenzylimidazol-2-yl) aufweisen. Soll eine Matrix für eine Emissionsschicht bereitgestellt werden, kann als Emittermaterial beispielsweise der gelbe Emitter Rubren (5,6,11,12-Tetraphenylnaphthacen) eingefügt werden.

Es wird weiterhin ein Verfahren zur Herstellung einer elektronischen Vorrichtung mit den oben beschriebenen Eigenschaften bereitgestellt. Das Verfahren umfasst die Verfahrensschritte A) Bereitstellen eines Substrats, B) Bereitstellen einer ersten Elektrode und einer zweiten Elektrode, C) Anordnen zumindest einer organischen Schicht zwischen der ersten Elektrode und der zweiten Elektrode Beispielsweise kann die zumindest eine organische, funktionelle Schicht auf der ersten Elektrode und die zweite Elektrode auf der organischen, funktionellen Schicht angeordnet werden. Im Verfahrensschritt C) wird dabei mindestens ein erstes Matrixmaterial, ein zweites Matrixmaterial und ein drittes Matrixmaterial gleichzeitig aufgebracht. Das Aufbringen im Verfahrensschritt C) kann beispielsweise durch Aufdampfen (Koevaporation) geschehen. Durch das gleichzeitige Aufbringen kann die Konzentration des jeweiligen Matrixmaterials unabhängig von den anderen Matrixmaterialien bestimmt werden, sodass die Matrixmaterialien in verschiedenen Konzentrationen aufgebracht werden können.

Anhand der Figuren und Ausführungsbeispiele soll die Erfindung näher erläutert werden:

Figur 1    zeigt die schematische Seitenansicht einer elektronischen Vorrichtung,

Figur 2    zeigt eine schematische Ansicht der energetischen Zustände der verschiedenen Matrixmaterialien,

Figur 3    zeigt eine schematische Seitenansicht einer elektronischen Vorrichtung,

Figur 4    zeigt die Simulation der Mobilität der Ladungsträger in einer Emissionsschicht,

Figur 5    zeigt den schematischen Aufbau zur Herstellung einer Schicht mit mehreren Matrixmaterialien.

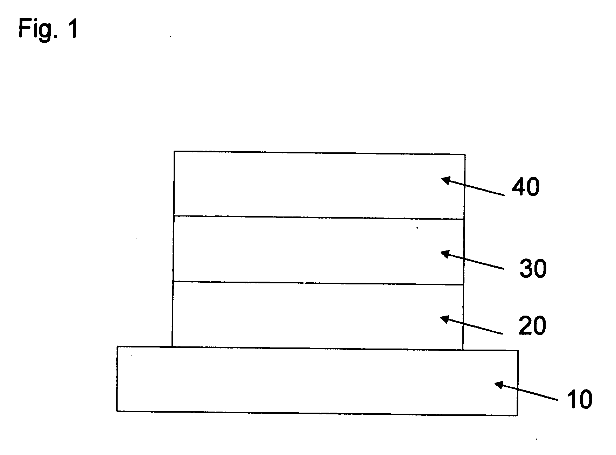

Figur 1 zeigt die schematische Seitenansicht einer elektronischen Vorrichtung, die ein Substrat 10, eine erste Elektrode 20, eine Emissionsschicht 30 und eine zweite Elektrode 40 umfasst. Die erste Elektrode kann beispielsweise eine Anode und die zweite Elektrode eine Kathode sein. Je nachdem, ob das Substrat und die erste Elektrode oder die zweite Elektrode transparent ausgeformt sind, kann es sich bei der elektronischen Vorrichtung um eine Bottomemittierende oder eine Top-emittierende Vorrichtung, beispielsweise eine OLED, handeln. Die Emissionsschicht 30 kann ein erstes, ein zweites und ein drittes Matrixmaterial aufweisen und mit einem Emittermaterial dotiert sein.

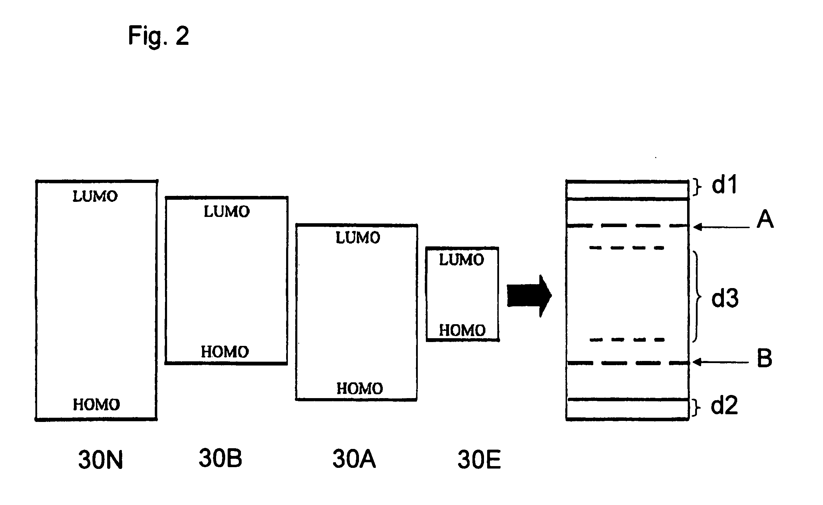

Figur 2 zeigt die schematische Darstellung der Energieniveaus der jeweiligen Materialien in der Emissionsschicht in einer beispielhaften Ausführungsform. Es ist das HOMO und LUMO des ersten Matrixmaterials 30N, des zweiten Matrixmaterials 30B und des dritten Matrixmaterials 30A gezeigt. Das erste Matrixmaterial weist ein HOMO auf, das energetisch niedriger liegt als das HOMO des zweiten Matrixmaterials und des dritten Matrixmaterials. Weiterhin weist das erste Matrixmaterial ein LUMO auf, das energetisch höher liegt als das LUMO des zweiten Matrixmaterials und des dritten Matrixmaterials. Das zweite Matrixmaterial weist ein LUMO auf, das energetisch höher liegt als das LUMO des dritten Matrixmaterials und ein HOMO, das energetisch höher liegt als das HOMO des dritten Matrixmaterials. Damit weist das erste Matrixmaterial geringere Ladungsträgermobilitäten als die beiden anderen Matrixmaterialien auf, das zweite Matrixmaterial kann ein Lochtransportmaterial und das dritte Matrixmaterial ein Elektronentransportmaterial umfassen.

Das Emittermaterial 30E weist ein HOMO und LUMO auf, das die geringste Bandlücke im Vergleich zu den Matrixmaterialien hat und zwischen den LUMOs und den HOMOs der drei Matrixmaterialien liegt.

Rechts in dem Schema ist die Summe der verschiedenen Energieniveaus aufgezeigt. A symbolisiert das Energieniveau, bei dem der Elektronentransport stattfindet, B symbolisiert das Energieniveau, bei dem Lochtransport stattfindet. d1 und d2 stehen für die energetischen Abstände zwischen den LUMOs des ersten und zweiten Matrixmaterials (d1) und den HOMOs des ersten und dritten Matrixmaterials (d2). d3 symbolisiert die Bandlücke des Emittermaterials. Wird kein Emittermaterial eingesetzt, kann es sich bei der Schicht auch um eine Ladungsträgertransport-, Ladungsträgerinjektions- oder Ladungsträgerblockierschicht handeln. Weiterhin können auch mehrere Emittermaterialien eingesetzt werden. Das Emittermaterial weist in der Emissionsschicht eine Konzentration von ≤ 10 Gew% auf.

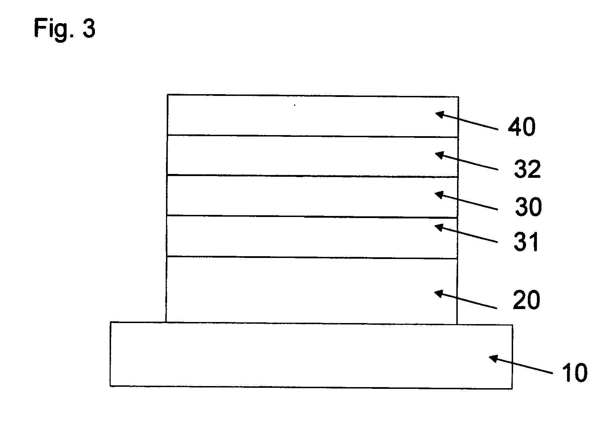

Figur 3 zeigt die schematische Seitenansicht einer weiteren Ausführungsform der elektronischen Vorrichtung, die eine Emissionsschicht 30 aufweist, an die jeweils auf einer Seite eine Elektronentransportschicht 32 und eine Lochtransportschicht 31 angrenzt. Hier handelt es sich bei der ersten Elektrode 20 um eine Anode. Sowohl die Emissionsschicht 30 als auch die Elektronentransportschicht 32 und die Lochtransportschicht 31 können Matrizen aufweisen, die sich aus drei oder mehr Matrixmaterialien zusammensetzen.

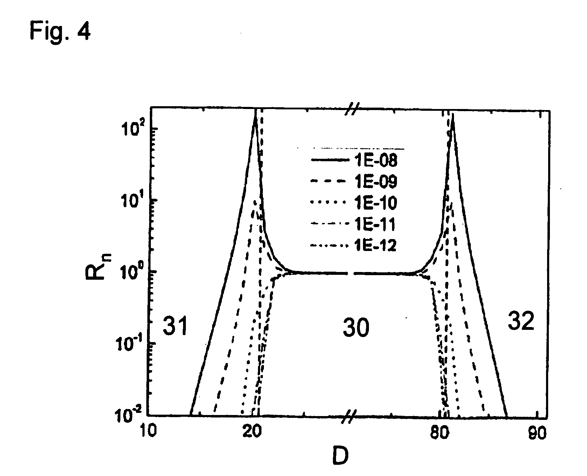

Figur 4 zeigt die Simulation des Ladungsträgertransports in einer OLED, in der eine Emissionsschicht, eine Lochtransportschicht 31 und eine Elektronentransportschicht 32 vorhanden ist. Die x-Achse zeigt die Entfernung der jeweiligen Schicht von der Anode D [nm], die y-Achse zeigt die normierte Rekombinationsrate $R_n$. Man kann sehen, dass mit Verringerung des absoluten Wertes der Ladungsträgermobilität in der Emissionsschicht 30 im Vergleich zu der Lochtransportschicht 31 und der Elektronentransportschicht 32 die Rekombinationszone von den Rändern der Emissionsschicht zur Mitte hin verschoben wird. Das heißt, mit sinkender Mobilität der Ladungsträger in der Emissionsschicht 30 verringert sich die Rekombination in den angrenzenden Schichten 32 und 31 und verschiebt sich zur Mitte der Emissionsschicht 30.

Bei der Simulation wurden Elektronen- und Lochmobilität in der Emissionsschicht gleichgesetzt, also ein ambipolarer Ladungstransport angenommen. Es wurde ohmsche Injektion angenommen, alle Energiebarrieren zwischen HOMO und LUMO der zwei Schichten betrugen 400 meV für die jeweilige Ladungsträgersorte. In dem Diagramm sind für die verschiedenen Linienformen die jeweiligen Mobilitäten der Ladungsträger in $m^2/Vs$ angegeben, sie bewegen sich zwischen $10^{-8}$ bis zu $10^{-12}$.

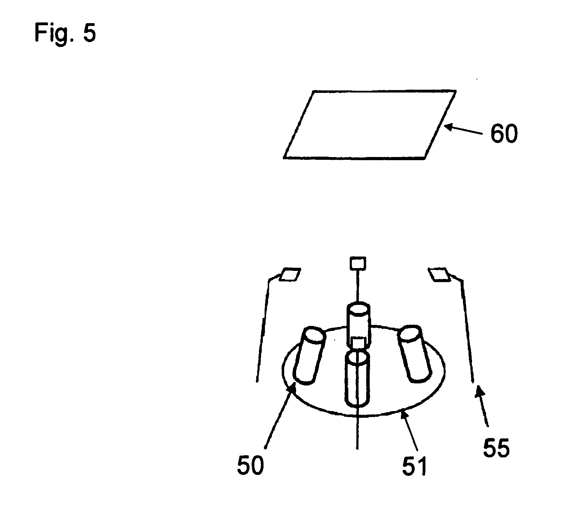

Figur 5 zeigt die schematische Seitenansicht eines Aufbaus zur Herstellung der elektronischen Vorrichtung. Auf einer Halterung 51 sind beispielhaft vier Verdampfungsquellen 50 aufgebracht, aus denen jeweils Matrixmaterialien und/oder Dotierstoffe auf das Abscheidesubstrat 60 aufgedampft werden können. Um die jeweilige Konzentration des Matrixmaterials und/oder des Dotierstoffs genau bestimmen zu können, wird die Verdampfungsrate über Schichtdickenmonitore 55 gemessen und eingestellt. Bei den Schichtdickenmonitoren kann es sich beispielsweise um Schwingquarze handeln.

Beispielsweise kann mit einem Aufbau gemäß Figur 5 eine Emissionsschicht hergestellt werden, die ein erstes Matrixmaterial enthält, das mCP (m-Bis(N-carbazolylbenzol)) umfasst und mit einer Aufdampfrate von 3,8 Å/s (1nm=10Å) aufgebracht wird. Das zweite Matrixmaterial, das Lochtransportmaterial kann TCTA (9H-carbazol, 9,9',9''- (1,3,5-Benzoltriyl)tris-(9Cl)) sein und mit einer Aufdampfrate von 8 Å/s aufgebracht werden. Das dritte Matrixmaterial, das Elektronentransportmaterial, kann beispielsweise TPBi (1,3,5-Tris(N-Phenylbenzylimidazol-2-yl) sein und mit einer Aufdampfrate von 8 Å/s aufgebracht werden. Als Emittermaterial kann beispielsweise der gelbe Emitter Rubren (5,6,11,12-Tetraphenylnaphthacen) eingebracht werden und mit einer Aufdampfrate von 0,2 Å/s aufgebracht werden. Damit ergibt sich eine Schicht mit einer Volumenkonzentration von 40% für die Ladungsträgertransportmaterialien und 1% für den Emitter. In Tabelle 1 sind die HOMOs und LUMOs dieser Materialien angegeben. Die Werte der HOMOs von TCTA, TPBi, mCP wurden mittels UV-Photoemissionsspektroskopie bestimmt, die korrespondierenden LUMO-Werte wurden abgeschätzt, indem die für die Absorption benötigte Energie zu dem HOMO-Wert dazugezählt wurde. Der HOMO- und LUMO-Wert von Rubren wurde mittels Cyclovoltammetrie und Photoelektronenspetrometrie bestimmt.

Tabelle 1

|  | HOMO [eV] | LUMO [eV] |
|---|---|---|
| mCP | -5,9 | -2,4 |
| TCTA | -5,7 | -2,3 |
| TPBi | -6,3 | -2,8 |
| Rubren | -5,5 | -3,0 |

Das dritte Matrixmaterial TPBi weist den im Vergleich mit den anderen Matrixmaterialien niedrigsten Wert für das LUMO auf und ist somit Elektronentransportmaterial. Das zweite Matrixmaterial TCTA weist den im Vergleich mit den anderen Matrixmaterialien größten Wert für das HOMO auf und ist somit Lochtransportmaterial. Das erste Matrixmaterial mCP ist nicht am Ladungsträgertransport beteiligt, da sein LUMO nicht niedriger als das LUMO des dritten Matrixmaterials ist und sein HOMO nicht höher als das HOMO des zweiten Matrixmaterials ist.

Weitere mögliche Lochtransportmaterialien sind:

| NPB | N,N'-Bis(Naphthalen-1-yl)-N,N'-bis(phenyl)-Benzidin |
|---|---|
| TCTA | 4,4',4''-Tris(carbazol-9-yl)triphenylamin |
| CPB | 4,4'-Bis(carbazol-9-yl)biphenyl |
| 1T-NATA | 4,4',4''-Tris(N-(1-naphthyl)-N-phenyl-amino)triphenylamin |
| Spiro-TAD | 2,2',7,7'-Tetrakis(N,N-diphenylamino)-9,9'-spirobifluoren |

Als Elektronentransportmaterialien können weiterhin eingesetzt werden:

| TPBi | 2,2',2''-(1,3,5-Benzintriyl)-tris(1-phenyl-1-H-benzimidazol) |
|---|---|
| TAZ | 3-(4-Biphenylyl)-4-Phenyl-5-tert-butylphenyl-1,2,4-triazol |
| $Alq_3$ | Tris(8-Hydroxy-quinolinato)aluminium |
| BCP | 2,9-Dimethyl-4,7-diphenyl-1,10-phenanthrolin |
| NTAZ | 4-(Naphthalen-1-yl)-3,5-diphenyl-4H-1,2,4-triazol |
| Balq | Bis-(2-methyl-8-quinolinolat)-4-(phenylphenolato)aluminium |

Als erstes Matrixmaterial, das im Vergleich zu den anderen Matrixmaterialien die geringste Ladungsträgermobilität aufweist, kann eingesetzt werden:

| UGH-2 | 1,4-Bis(triphenylsilyl)benzol |
|---|---|
| UGH-3 | 1,3-Bis(triphenylsilyl)benzol |
| mCP | 1,3-Bis(carbazol-9-Yl)benzol |

Die HOMOs von UGH-2 und UGH-3 haben Werte von -7,2 $\pm$ 0,1 eV, die LUMOs liegen bei 2,8 eV. Diese HOMO-Werte können mittels Photoelektronenspektroskopie bestimmt werden, die LUMO-Werte können aus dem Abstand von HOMO-Werten und LUMO-Werten am Schnittpunkt des Absorptions- und des Fluoreszenzspektrums abgeschätzt werden.

Mögliche Emittermaterialien sind:

| $Ir(ppy)_3$ | Tris(2-phenylpyridin)iridum(III) |
|---|---|
| $Ir(ppy)_2$ (acac) | Bis(2-phenylpyridlin)(acetylacetonat)iridium(II) |
| BczVBi | 4,4'-Bis(9-ethyl-3-carbazovinylen)-1,1'-biphenyl |
| FirPic | Bis(3,5-Difluoro-2-(2-pyridyl)phenyl-(2-carboxy-pyridyl)iridium(III) |
| Rubren | Tetraphenylnaphthacen |
| $Ir(piq)_3$ | Tris(1-phenylisoquinolin)iridium(III) |

Bei diesen Emittermaterialien handelt es sich um kleine, nicht-polymere Moleküle. Der Einsatz von polymeren Emittermaterialien ist ebenso möglich.

Weitere mögliche Materialien, die je nach Lage ihrer HOMOs und LUMOs zueinander als erste, zweite oder dritte Matrix eingesetzt werden können, sind:

| Bphen | 4,7-Diphenyl-1,10-phenanthrolin |
|---|---|
| DPAVBi | 4,4'-Bis(2-(4-(N,N-diphenylamino)phenyl)vinyl)biphenyl |
| CuPC | Phthalocyanin Kupfer Komplex |
| S-DPVBi | 2,2',7,7'-Tetrakis(2,2-diphenylvinyl)spiro-9,9'-bifluorenCPF |
| TAPC | 1,1-Bis-(4-bis(4-methylphenyl)-aminophenyl)-cyclohexan |
| TBADN | 9,10-Bis(2-naphthyl)-2-t-butylanthracen |
| TPD | N,N,N',N'-Tetraphenylbenzidin |

Einige der Elektronen- und Lochtransportmaterialien können auch als erstes Matrixmaterial dienen. Wichtig bei der Zusammenstellung des ersten, zweiten und dritten Matrixmaterials für die Matrix sind das relative Verhältnis der LUMOs und HOMOs der drei kombinierten Materialien und deren Lage zueinander.

Die Matrix kann für phosphoreszente Emitter aufgrund der chemischen Verträglichkeit nicht beliebig gewählt werden. Der rote Emitter Iridium (III)bis(2-methyldibenzo-[f,h]quinoxalin)-acetylacetonat) ist nur in einer NBP-Matrix effizient. NPB ist jedoch ein Lochtransportmaterial. Befindet sich nun anodenseitig noch eine weitere Emitterschicht, wird diese nicht ausreichend mit Elektronen versorgt. Durch Eindotierung eines Elektronentransportmaterials, beispielsweise BCP, können die relativen Transporteigenschaften eingestellt werden. Die Feinabstimmung der Transporteigenschaften erfolgt mit UGH4.

Die in den Figuren und Ausführungsbeispielen gezeigten Ausführungsformen können beliebig variiert werden. Es ist weiterhin zu berücksichtigen, dass sich die Erfindung nicht auf die Beispiele beschränkt, sondern weitere, hier nicht aufgeführte Ausgestaltungen zulässt.

**Patentansprüche**

1. Elektronische Vorrichtung, umfassend

   - ein Substrat (10),
   - eine erste Elektrode (20),
   - zumindest eine organische, funktionelle Schicht, und
   - eine zweite Elektrode (40), wobei die zumindest eine organische, funktionelle Schicht zwischen der ersten Elektrode (20) und der zweiten Elektrode (40) angeordnet ist und wobei die zumindest eine organische, funktionelle Schicht mindestens ein erstes Matrixmaterial (30N), ein zweites Matrixmaterial (30B) und ein drittes Matrixmaterial (30A) aufweist und das dritte Matrixmaterial (30A) ein Lowest Unoccupied Molecular Orbital (LUMO), das energetisch niedriger als das LUMO des zweiten Matrixmaterials (30B) und das LUMO des ersten Matrixmaterials (30N) ist, und wobei das zweite Matrixmaterial (30B) ein Highest Occupied Molecular Orbital (HOMO), das energetisch höher als das HOMO des ersten Matrixmaterials (30N) und das HOMO des dritten Matrixmaterials (30A) ist, aufweist, **dadurch gekennzeichnet, daß** die zumindest eine organische, funktionelle Schicht eine Emissionsschicht ist und mit zumindest einem Emittermaterial (30E) dotiert ist.

2. Elektronische Vorrichtung nach dem vorhergehenden Anspruch, wobei das erste Matrixmaterial (30N) ein LUMO, das energetisch höher als das LUMO des zweiten Matrixmaterial (30B) und das LUMO des dritten Matrixmaterials (30A) ist, und ein HOMO, das energetisch niedriger als das HOMO des zweiten Matrixmaterials (30B) und das HOMO des dritten Matrixmaterials (30A) ist, aufweist.

3. Elektronische Vorrichtung nach dem vorhergehenden Anspruch, wobei das zweite Matrixmaterial (30B) ein LUMO, das energetisch höher als das LUMO des dritten Matrixmaterials (30A) ist, und ein HOMO, das energetisch höher als das HOMO des dritten Matrixmaterials (30A) ist, aufweist.

4. Elektronische Vorrichtung nach einem der vorhergehenden Ansprüche, wobei das erste Matrixmaterial (30N) eine Ladungsträgermobilität aufweist, die geringer ist als die Ladungsträgermobilitäten des zweiten und dritten Matrixmaterials (30A).

5. Elektronische Vorrichtung nach einem der vorhergehenden Ansprüche, wobei das zweite Matrixmaterial (30B) ein Lochtransportmaterial umfasst.

6. Elektronische Vorrichtung nach einem der vorhergehenden Ansprüche, wobei das dritte Matrixmaterial (30A) ein Elektronentransportmaterial umfasst.

7. Elektronische Vorrichtung nach einem der vorhergehenden Ansprüche, die weitere organische, funktionelle Schichten umfasst, welche ausgewählt sind aus einer Gruppe, die Emissionsschichten, Elektronentransportschichten, Lochtransportschichten, Elektronenblockierschichten, Lochblockierschichten, Lochinjektionsschichten, Elektroneninjektionsschichten und Zwischenschichten umfasst.

8. Elektronische Vorrichtung nach einem der vorhergehenden Ansprüche, wobei das Emittermaterial (30E) in der Emissionsschicht eine Konzentration von $\leq$ 10 Gew% aufweist.

9. Elektronische Vorrichtung nach dem vorhergehenden Anspruch, wobei die Konzentration des Emittermaterials (30E) in der Emissionsschicht einen Gradienten aufweist.

**10.** Elektronische Vorrichtung nach einem der vorhergehenden Ansprüche, wobei das LUMO des Emittermaterials (30E) energetisch niedriger als das LUMO des ersten, zweiten und dritten Matrixmaterials (30B, 30A) ist und das HOMO des Emittermaterials (30E) energetisch höher als das HOMO des ersten, zweiten und dritten Matrixmaterials (30N, 30B, 30A) ist.

**11.** Elektronische Vorrichtung nach einem der vorhergehenden Ansprüche, die als strahlungsemittierende Vorrichtung ausgebildet ist.

**12.** Elektronische Vorrichtung nach einem der Ansprüche 1 bis 10, die als eine organische Licht emittierende Vorrichtung ausgebildet ist.

**13.** Verfahren zur Herstellung einer elektronischen Vorrichtung gemäß den Ansprüchen 1 bis 12, mit den Verfahrensschritten

A) Bereitstellen eines Substrats (10),
B) Bereitstellen einer ersten Elektrode (20) und einer zweiten Elektrode (40),
C) Anordnen zumindest einer organischen, funktionellen Schicht zwischen der ersten Elektrode (20) und der zweiten Elektrode (40)

wobei im Verfahrensschritt C) mindestens das erste Matrixmaterial (30N), das zweite Matrixmaterial (30B) und das dritte Matrixmaterial (30A) gleichzeitig aufgebracht werden.

**14.** Verfahren nach dem vorhergehenden Anspruch, wobei im Verfahrensschritt C) das erste Matrixmaterial (30N), das zweite Matrixmaterial (30B) und das dritte Matrixmaterial (30A) durch Aufdampfen aufgebracht werden.

**Claims**

**1.** Electronic device, comprising

- a substrate (10),
- a first electrode (20),
- at least one organic functional layer, and
- a second electrode (40), wherein the at least one organic functional layer is arranged between the first electrode (20) and the second electrode (40) and wherein the at least one organic functional layer comprises at least a first matrix material (30N), a second matrix material (30B) and a third matrix material (30A) and the third matrix material (30A) has a lowest unoccupied molecular orbital (LUMO), that is energetically lower than the LUMO of the second matrix material (30B) and the LUMO of the first matrix material (30N), and wherein the second matrix material (30B) has a highest occupied molecular orbital (HOMO), that is energetically higher than the HOMO of the first matrix material (30N) and the HOMO of the third matrix material (30A), **characterized in that** the at least one organic functional layer is an emission layer and is doped with at least one emitter material (30E).

**2.** Electronic device according to the preceding claim, wherein the first matrix material (30N) has a LUMO that is energetically higher than the LUMO of the second matrix material (30B) and the LUMO of the third matrix material (30A), and has a HOMO that is energetically lower than the HOMO of the second matrix material (30B) and the HOMO of the third matrix material (30A).

**3.** Electronic device according to the preceding claim, wherein the second matrix material (30B) has a LUMO that is energetically higher than the LUMO of the third matrix material (30A), and has a HOMO that is energetically higher than the HOMO of the third matrix material (30A).

**4.** Electronic device according to any of the preceding claims, wherein the first matrix material (30N) has a charge carrier mobility that is lower than the charge carrier mobilities of the second and the third matrix material (30A).

**5.** Electronic device according to any of the preceding claims, wherein the second matrix material (30B) comprises a hole transport material.

**6.** Electronic device according to any of the preceding claims, wherein the third matrix material (30A) comprises an electron transport material.

7. Electronic device according to any of the preceding claims, which comprises further organic functional layers selected from a group comprising emission layers, electron transport layers, hole transport layers, electron blocking layers, hole blocking layers, hole injection layers, electron injection layers and intermediate layers.

8. Electronic device according to any of the preceding claims, wherein the emitter material (30E) in the emission layer has a concentration of $\leq$ 10% by weight.

9. Electronic device according to the preceding claim, wherein the concentration of the emitter material (30E) in the emission layer has a gradient.

10. Electronic device according to any of the preceding claims, wherein the LUMO of the emitter material (30E) is energetically lower than the LUMO of the first, the second and the third matrix material (30B, 30A) and the HOMO of the emitter material (30E) is energetically higher than the HOMO of the first, the second and the third matrix material (30N, 30B, 30A).

11. Electronic device according to any of the preceding claims, which is embodied as a radiation-emitting device.

12. Electronic device according to any of Claims 1 to 10, which is embodied as an organic light-emitting device.

13. Method for producing an electronic device according to Claims 1 to 12, comprising the following method steps:

   A) providing a substrate (10),
   B) providing a first electrode (20) and a second electrode (40),
   C) arranging at least one organic functional layer between the first electrode (20) and the second electrode (40), wherein in method step C) at least the first matrix material (30N), the second matrix material (30B) and the third matrix material (30A) are applied simultaneously.

14. Method according to the preceding claim, wherein in method step C) the first matrix material (30N), the second matrix material (30B) and the third matrix material (30A) are applied by vapour deposition.


**Revendications**

1. Dispositif électronique, comprenant :

   - un substrat (10),
   - une première électrode (20),
   - au moins une couche organique fonctionnelle, et
   - une deuxième électrode (40), dans lequel l'au moins une couche organique fonctionnelle est disposée entre la première électrode (20) et la deuxième électrode (40) et dans lequel l'au moins une couche organique fonctionnelle comprend au moins un premier matériau de matrice (30N), un deuxième matériau de matrice (30B) et un troisième matériau de matrice (30A) et le troisième matériau de matrice (30A) présente une Orbitale Moléculaire Inoccupée la plus Basse (LUMO, Lowest Unoccupied Molecular Orbital) qui est d'énergie inférieure à celle de l'orbitale LUMO du deuxième matériau de matrice (30B) et de l'orbitale LUMO du premier matériau de matrice (30N), et dans lequel le deuxième matériau de matrice (30B) présente une Orbitale Moléculaire Occupée la plus Haute (HOMO, Highest Occupied Molecular Orbital) qui est d'énergie supérieure à celle de l'orbitale HOMO du premier matériau de matrice (30N) et de l'orbitale HOMO du troisième matériau de matrice (30A), **caractérisé en ce que** l'au moins une couche organique fonctionnelle est une couche d'émission et est dopée par au moins un matériau d'émetteur (30E).

2. Dispositif électronique selon la revendication précédente, dans lequel le premier matériau de matrice (30N) présente une orbitale LUMO qui est d'énergie supérieure à celle de l'orbitale LUMO du deuxième matériau de matrice (30B) et de l'orbitale LUMO du troisième matériau de matrice (30A), et qui présente une orbitale HOMO qui est d'énergie inférieure à celle de l'orbitale HOMO du deuxième matériau de matrice (30B) et de l'orbitale HOMO du troisième matériau de matrice (30A).

3. Dispositif électronique selon la revendication précédente, dans lequel le deuxième matériau de matrice (30B) présente une orbitale LUMO qui est d'énergie supérieure à celle de l'orbitale LUMO du troisième matériau de matrice (30A) et une orbitale HOMO qui est d'énergie supérieure à celle de l'orbitale HOMO du troisième matériau de matrice (30A).

4. Dispositif électronique selon l'une quelconque des revendications précédentes, dans lequel le premier matériau de matrice (30N) présente une mobilité des porteurs de charge qui est inférieure aux mobilités des porteurs de charge des deuxième et troisième matériaux de matrice (30A).

5. Dispositif électronique selon l'une quelconque des revendications précédentes, dans lequel le deuxième matériau de matrice (30B) comprend un matériau de transport de trous.

6. Dispositif électronique selon l'une quelconque des revendications précédentes, dans lequel le troisième matériau de matrice (30A) comprend un matériau de transport d'électrons.

7. Dispositif électronique selon l'une quelconque des revendications précédentes, comprenant des couches organiques fonctionnelles supplémentaires qui sont sélectionnées dans un groupe comprenant des couches d'émission, des couches de transport d'électrons, des couches de transport de trous, des couches de blocage d'électrons, des couches de blocage de trous, des couches d'injection de trous, des couches d'injection d'électrons et des couches intermédiaires.

8. Dispositif électronique selon l'une quelconque des revendications précédentes, dans lequel le matériau d'émetteur (30E) présente une concentration $\leq$ 10 % en poids dans la couche d'émission.

9. Dispositif électronique selon la revendication précédente, dans lequel la concentration du matériau d'émetteur (30E) dans la couche d'émission présente un gradient.

10. Dispositif électronique selon l'une quelconque des revendications précédentes, dans lequel l'orbitale LUMO du matériau d'émetteur (30E) est d'énergie inférieure à celle de l'orbitale LUMO des premier, deuxième et troisième matériaux de matrice (30B, 30A) et dans lequel l'orbitale HOMO du matériau d'émetteur (30E) est d'énergie supérieure à celle de l'orbitale HOMO des premier, deuxième et troisième matériaux de matrice (30N, 30B, 30A).

11. Dispositif électronique selon l'une quelconque des revendications précédentes, réalisé sous la forme d'un dispositif émetteur de rayonnement.

12. Dispositif électronique selon l'une quelconque des revendications 1 à 10, réalisé sous la forme d'un dispositif électroluminescent organique.

13. Procédé de fabrication d'un dispositif électronique selon les revendications 1 à 12, comprenant les étapes de procédé consistant à :

A) fournir un substrat (10),
B) fournir une première électrode (20) et une deuxième électrode (40),
C) disposer au moins une couche organique fonctionnelle entre la première électrode (20) et la deuxième électrode (40), dans lequel au moins le premier matériau de matrice (30N), le deuxième matériau de matrice (30B) et le troisième matériau de matrice (30A) sont déposés simultanément lors de l'étape de procédé C).

14. Procédé selon la revendication précédente, dans lequel le premier matériau de matrice (30N), le deuxième matériau de matrice (30B) et le troisième matériau de matrice (30A) sont déposés par dépôt sous vide lors de l'étape de procédé C).

Fig. 1

40

30

20

10

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008025920
- DE 102008039361
- US 20080116536 A
- US 2006068223 A